# EUROPEAN PATENT SPECIFICATION

(11) **EP 1 036 986 B1**
(45) Date of publication and mention of the grant of the patent: **15.09.2004**
(21) Application number: 99105510.4
(22) Date of filing: 17.03.1999
(51) Int. Cl.: F23H 17/12, F23H 1/02

(54) **Stepped grate for a waste incineration plant**
Stufenförmiger Rost für eine Abfallverbrennungsanlage
Grille à gradins destinée à une installation d'incinération de déchets

(43) Date of publication of application: 20.09.2000
(73) Proprietor: Babcock & Wilcox Voelund ApS, 6705 Esbjerg (DK)
(72) Inventor: Olsen, Erik, 2635 Ishoej (DK); Mogensen, Erhardt, 4100 Ringsted (DK)
(74) Representative: Roerboel, Leif

(56) References cited:
- EP-A- 0 115 242
- GB-A- 2 120 367

## Description

### TECHNICAL FIELD

The present invention relates to a stepped grate for a waste incineration plant of the kind set forth in the preamble of claim 1.

### BACKGROUND ART

From GB-2120 764 it is known to provide a stepped grate of this kind, in which the grate bars and grate block stringers consist of cast iron. One of the advantages of this grate is simple maintenance as all grate girders and grate bars can be lifted vertically up into the furnace above the grate without anyone going under the grate and only simple hand tools are needed for cleaning and maintaining the grate. Furthermore, the grate is designed to maintain a low intrinsic pressure drop over the grate in the range 50-100 Pa. The typical maintenance and cleaning of this type of grate takes place 2-3 times a year, and the typical lifetime for a cast iron grate bar is approx. 3-4 years, both highly dependent on the calorific content of the waste to be incinerated. Traditionally, the grate bars having a width of 21 mm were filled into the grate block and possible tolerances were compensated by filling the open spaces with shims of a width of 6 and 9 mm. During the reciprocating movement of the movable grate beams these shims have shown a tendency of being pushed up and out of the grate block, whereby the grate bars can tilt and also be pushed out of the grate block by the waste during incineration, whereby a whole row of grate blocks may lose all its grate bars and thus develop unintended open holes eventually of a size corresponding to the size of the grate girders in the incineration grate.

### DISCLOSURE OF THE INVENTION

It is the object of the invention to provide a stepped grate bar of the kind referred to above, with which it is possible to obtain a greater availability, i.e. longer lifetime and longer time between cleaning and maintenance, and which allows the burning of high calorific waste having a lower heating value in the range 10-15 MJ/kg. According to the present invention this is achieved with a stepped grate of said kind which comprises the features set forth in the characterizing part of claim 1. In this way, it is possible to avoid the provision of water cooling or the use of very costly high alloy steel materials for the grate bars, thereby maintaining the above mentioned advantages associated with the simple construction of the air-cooled grates. The grates, in accordance with the invention, has furthermore the advantage of remaining cleaner for significantly longer times than the traditional cast iron types. Advantageous embodiments of the invention, the nature of which will be evident from the following detailed description of the invention, are revealed in the subordinate claims.

### BRIEF DESCRIPTION OF THE DRAWINGS

In the following detailed part of the present description, the invention will be explained in more details with reference to the exemplary embodiment of a stepped grate according to the invention shown in the drawings, in which
Fig. 1 shows a vertical section through three succeeding stepped grates of an incineration plant,
Fig. 2 shows a grate block in perspective,
Fig. 3 shows a grate bar seen from the side,
Fig. 4 shows the grate bar of Fig. 3 seen from above, and
Fig. 5 shows a grate bar for use at the lowermost grate block at the rear.
(*Front* is used to indicate the infeed end of the grate, and *rear* is used to indicate the outlet end of the grate).

### DESCRIPTION OF THE PREFERRED EMBODIMENT

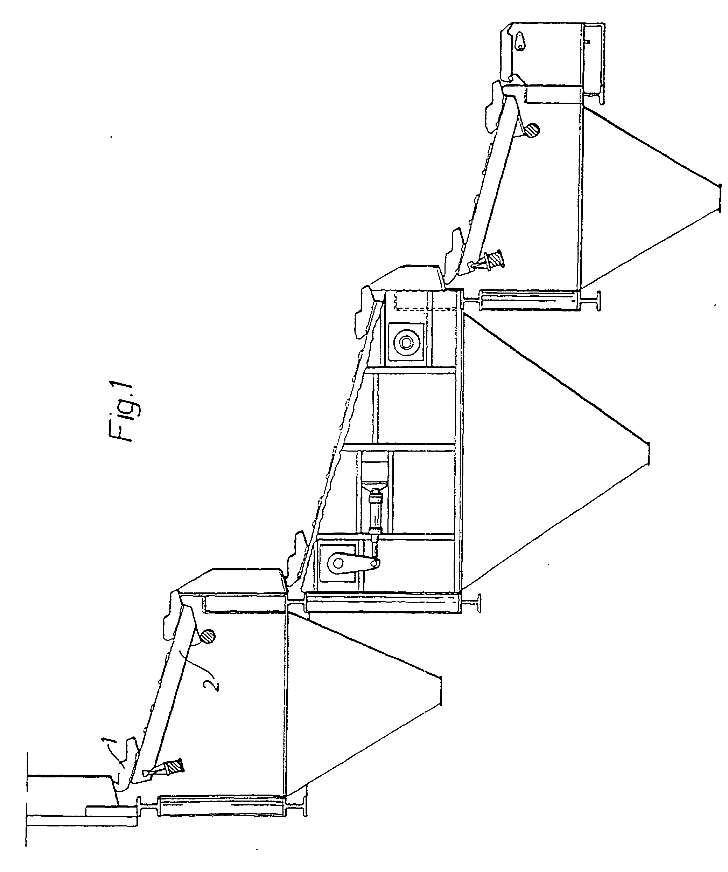

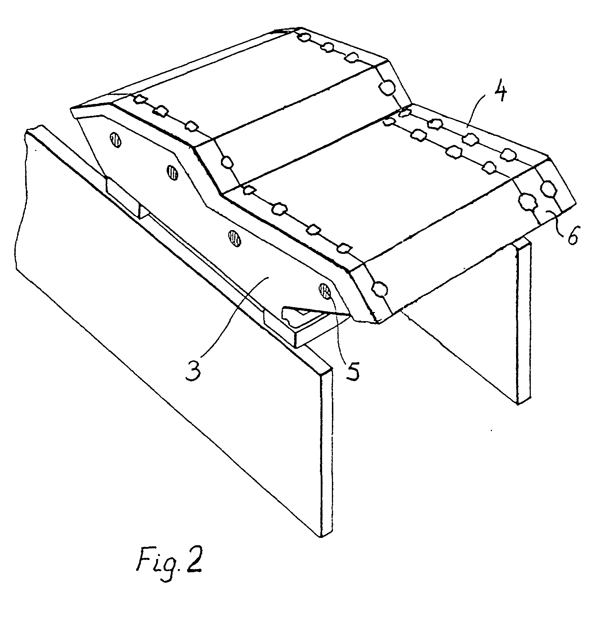

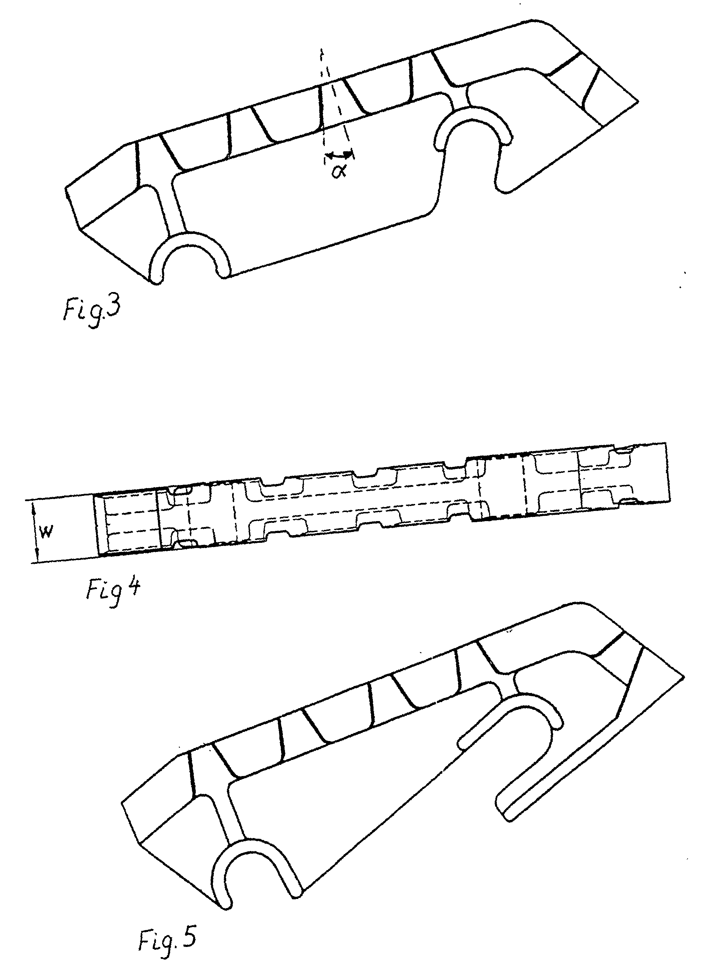

The stepped grate for a waste incineration plant shown in Fig. 1 consists of three sections, each section comprising stationary and reciprocating grate girders. Each girder consists of a grate beam 2, on which grate blocks 1 are fixed. Every second grate girder is adapted to make a reciprocating movement while the intermediate girders are stationary.
Each grate block, as shown in Fig. 2, consists of two cast stringers, 3, 4 mutually connected by two or four transverse steel rods 5. The grate block 1 is filled up with cast grate bars 6 which are resting on the steel rods 5. The grate bars are, as shown in Figs. 3-5, provided with suitable bearing elements for supporting the grate bars 6 on the transverse steel rods 5.

The grate bars 6, are preferably provided in two different widths in order to be able to fill out the grate blocks completely within a certain tolerance. In a preferred embodiment, the two different widths of the grate bars are 25 mm and 30 mm, respectively, whereby any dimension above 100 mm may be provided by combinations of those two different widths within a tolerance of 5 mm.

The primary air for the combustion, which enters into the furnace from below as seen in Fig. 1 and through the stepped grate, passes along the sides of the grate bars, these sides being provided with indentations as shown in Figs. 3-5. The indentations in adjacent grate bars are positioned to provide holes with an average distance of approx. 30 - 70 mm, and in the preferred embodiment the hole size in the tops of the grate bars has the dimensions 8 x 12 mm². As shown in Figs. 3-5 the holes in the grate bars have an opening slope down through the hole which in the preferred embodiment forms an angle (α) of approx. 14 °.

The form of the grate bar shown in Fig. 5 is suited for placement as the lowermost row of grate bars on a grate girder and comprises a hook-formed bearing at the front securing the grate bar against lifting up the front end of said grate bar when it is moving relative to the rear edge of the grate section. The hook shape is also adopted to follow closely the surface of the grate transition element thus providing an impediment to the ingress of undesired parasitic combustion air.

In accordance with the invention the grate bars 6 and the grate block stringers 3, 4 are cast from a steel alloy comprising 22-30% Cr, 2-10% Ni, 0.5-1.5% Mn, and 0.2-0.8% C. The specified ranges for these four ingredients allow for optimization of each of the above mentioned grate block stringers 3, 4 and grate bars 6 as concerns manufacturing costs, requirements for weldability (especially the grate block stringers, 3, 4), level of ductility, brittleness and durability inside the waste furnace.

These cast grate bars 6 and grate block stringers 3, 4 have better heat resisting properties than the traditional cast iron grate bars and stringers and furthermore provide a smoother surface, thereby also improving the self-cleaning features of the grate system compared to the cast iron types. Sticky ashes, molten metals and slag pieces have less tendency to clog the grate system in accordance with the invention.

Furthermore, the average durability of the grate bars 6 and the grate block stringers 3, 4 is also improved compared to the cast iron types to an average lifetime of 5-8 years, which together with the above mentioned selfcleaning properties keeps the grate system available for significantly longer times between cleaning and maintaining the grates.

With grate block stringers 3, 4 and grate bars 6, in accordance with the invention, it is possible to maintain a low intrinsic pressure drop over the grate in a range 50-100 Pa and at the same time allowing high calorific waste having a lower heating value in the range 10-15 MJ/kg to be burned on the grates which is cooled by the primary air only.

The grate in accordance with the invention is suited to be used in connection with larger furnaces and grates which are designed to be used for supplying heat to steam boilers with or without steam turbines for electric power generation, where long availability and low need for maintenance is requested, providing an availability greater than e.g. 8000 hours a year.

## Claims

1. Stepped grate for a waste incineration plant consisting of grate blocks (1) placed in adjacent rows and in succession in the advancing direction of the waste and resting on parallel grate beams (2), in which every second row of grate blocks (1) are adapted to make a reciprocating movement while the intermediate rows of grate blocks (1) are stationary, wherein each grate block (1) comprises:
two stringers (3, 4) mutually connected by two (half-blocks) or four transverse steel rods (5) and each grate block (1) being filled up with loose, vertically hanging cast grate bars (6) resting on said steel rods (5), said grate bars (6) comprising indentations along their abutting sides forming holes for admitting primary air for the combustion, said primary air also providing the necessary cooling of the grate bars (6), **characterised by** said cast grate bars (6) and grate block stringers (3, 4) consisting of a steel alloy comprising:
22-30% Cr
2-10% Ni
0.5-1.5% Mn, and
0.2 - 0.8% C
and
the indentations along the abutting sides of the grate bars (6) being dimensioned and positioned to provide holes with an average distance of approx. 30-70 mm and a hole size of more than 70 mm², preferably approx. 100 mm².

2. Grate in accordance with claim 1, **characterised by** the holes for admitting primary air having an opening slope (α) down through the hole of more than 12°, preferably approx. 14°.

3. Grate in accordance with claim 1 or 2, **characterised by** the grate blocks (1) being filled up with a suitable combination of grate bars (6) with at least two different widths.

4. Grate in accordance with claim 3, **characterised by** the grate blocks (1) being filled up with grate bars of width 25 mm and 30 mm, respectively.

5. Grate in accordance with any of the preceding claims, **characterised by** the grate bars for placement as the lowermost row of grate bars on a grate girder comprising a hook-formed bearing at the front for securing the grate bar against lifting up during operation.

## Patentansprüche

1. Stufenrost für eine Müllverbrennungsanlage, die aus in angrenzenden Reihen und aufeinanderfolgend in Vorschubrichtung des Abfalls und auf parallelen Rostschienen (2) aufliegenden Rostblöcken (1), bei denen jede zweite Reihe von Rostblöcken (1) dafür ausgelegt ist, eine hin und her gehende Bewegung zu vollführen, während die Zwischenreihen der Rostblöcke (1) stationär sind, wobei jeder Rostblock (1) umfasst:
zwei Holme (3, 4), die aneinander durch zwei (Halbblöcke) oder.vier quer laufende Stahlstäbe (5) verbunden sind und wobei jeder Rostblock (1) mit losen, vertikal hängenden Gussroststäben (6) gefüllt ist, die auf den Stahlstäben (5) aufliegen, wobei die Roststäbe (6) Vertiefungen längs ihrer anstoßenden Seiten umfassen, die Löcher zum Durchlassen von Primärluft für die Verbrennung bilden, wobei die Primärluft auch die notwendige Kühlung der Roststäbe (6) bereitstellt, **dadurch gekennzeichnet, dass** die Gussroststäbe (6) und Rostblockholme (3, 4) aus einer Stahllegierung bestehen, die umfasst:
22 bis 30 % Cr
2 bis 10 % Ni
0,5 bis 1,5 % Mn, und
0,2 bis 0,8 % C
und
die Vertiefungen längs der anstoßenden Seiten der Roststäbe (6) dafür dimensioniert und positioniert sind, Löcher mit einem durchschnittlichen Abstand von ungefähr 30 bis 70 mm und einer Lochgröße von mehr als 70 mm², vorzugsweise ungefähr 100 mm², bereitzustellen.

2. Rost gemäß Anspruch 1, **dadurch gekennzeichnet, dass** die Löcher zum Zuführen von Primärluft eine Öffnungsneigung (α) hinab durch das Loch von mehr als 12°, vorzugsweise ungefähr 14° aufweisen.

3. Rost gemäß Anspruch 1 oder 2, **dadurch gekennzeichnet, dass** die Rostblöcke (1) mit einer geeigneten Kombination von Roststäben (6) von zumindest zwei unterschiedlichen Breiten aufgefüllt sind.

4. Rost gemäß Anspruch 3, **dadurch gekennzeichnet, dass** die Rostblöcke (1) mit Roststäben mit Breiten von 25 bzw. 30 mm aufgefüllt sind.

5. Rost gemäß einem der vorstehenden Ansprüche, **dadurch gekennzeichnet, dass** die Roststäbe zum Platzieren auf der untersten Reihe von Roststäben auf einem Rostholm ein hakenförmiges Lager an der Front zum Sichern des Roststabs gegenüber einem Hochheben während des Betriebs umfassen.

## Revendications

1. Grille à gradins pour une installation d'incinération de déchets, comprenant des blocs de grilles (1) placés en rangées adjacentes et en succession dans la direction de progression des déchets et reposant sur des poutres de grilles parallèles (2), dans lesquels une rangée de blocs de grilles sur deux (1) est adaptée à effectuer un mouvement de va-et-vient alors que les rangées intermédiaires de blocs de grille (1) sont stationnaires, dans lesquels chaque bloc de grille (1) comprend :
deux longrines (3, 4) mutuellement connectées par deux demi-blocs ou par quatre barres d'acier transversales (5), et chaque bloc de grille (1) est rempli avec des barres de grilles de fonderie (6) lâches et pendues verticalement, qui reposent sur lesdites barres d'acier (5), lesdites barres de grilles (6) comprenant des encoches le long de leurs côtés en butée, formant des trous pour admettre de l'air primaire pour la combustion, ledit air primaire assurant également le refroidissement nécessaire des barres de grilles (6), **caractérisée en ce que** lesdites barres de grilles de fonderie (6) et lesdites longrines (3, 4) des blocs de grilles sont constituées en un alliage d'acier comprenant :
22 à 30 % de Cr
2 à 10 % de Ni
0,5 à 1,5 % de Mn, et
0,2 à 0,8 % de C,
et les encoches le long des côtés en butée des barres de grilles (6) sont dimensionnées et positionnées pour constituer des trous avec une distance moyenne d'approximativement 30 à 70 mm, et une taille de trous supérieure à 70 mm², de préférence approximativement 100 mm².

2. Grille selon la revendication 1, **caractérisée en ce que** les trous pour admettre l'air primaire ont une pente d'ouverture (α), en descendant à travers le trou, supérieure à 12°, de préférence approximativement 14°.

3. Grille selon l'une ou l'autre des revendications 1 et 2, **caractérisée en ce que** les blocs de grilles (1) sont remplis d'une combinaison appropriée de barres de grilles (6) avec au moins deux largeurs différentes.

4. Grille selon la revendication 3, **caractérisée en ce que** les blocs de grilles (1) sont remplis avec des barres de grilles d'une largeur de 25 mm et de 30 mm respectivement.

5. Grille selon l'une quelconque des revendications précédentes, **caractérisée en ce que** les barres de grilles destinées à être placées à titre de rangée la plus basse de barres de grilles sur un cadre de grille comprend un support en forme de crochet à la partie frontale pour bloquer la barre de grilles à l'encontre d'un soulèvement pendant le fonctionnement.
